# EUROPEAN PATENT SPECIFICATION

(11) **EP 2 410 657 B1**
(45) Date of publication and mention of the grant of the patent: **22.05.2013**
(21) Application number: 11172679.0
(22) Date of filing: 05.07.2011
(51) Int. Cl.: H01H 21/02, H03K 17/95, H03K 17/97, G01D 5/14

(54) **Tilting operation type input device**
Eingabevorrichtung mit Neigungssteuerung
Dispositif d'entrée à fonctionnement de basculage

(30) Priority: 22.07.2010 JP 2010164988
(43) Date of publication of application: 25.01.2012
(73) Proprietor: Alps Electric Co., Ltd., Tokyo 145-8501 (JP)
(72) Inventor: Sugino, Naoki, Tokyo 145-8501 (JP); Konno, Satoru, Tokyo 145-8501 (JP)
(74) Representative: Klunker . Schmitt-Nilson . Hirsch

(56) References cited:
- EP-A1- 2 099 045
- DE-C1- 10 005 749
- GB-A- 2 375 890
- US-A1- 2008 106 873

## Description

### BACKGROUND OF THE INVENTION

### 1. Field of the Invention

The present invention relates to a tilting operation type input device capable of detecting a rotational operation angle of a tiltable operation knob by a detection means, and particularly, to a rotatable attachment configuration of a operation knob in a tilting operation type input device to which relatively great operation force is applied.

### 2. Description of the Related Art

In the related art, as switch devices or the like capable of generating a signal for controlling the driving of a switching motor in a power window of automobile, there is known an input device that detects a rotational operation angle of a tiltable operation knob by a detection means and takes out a predetermined input signal. In this kind of input device, it is possible to adopt a contact type detection mechanism slidingly abutting a slider to a conductive pattern. However, when adopting a non-contact type detection mechanism that detects a variation in a magnetic field of a magnet by a magnetic sensor, since a contact failure due to an abrasion can be avoided, lengthening of service life is achieved.

In the input device of the related art (for example, refer to JP-A-2001-118465) capable of detecting the rotational operation angle of the tiltable operation knob by the magnetic sensor, a circuit mechanism, in which the magnetic sensor, a signal processing circuit and like are disposed, is assembled down the operation knob rotatably supported, the magnet is disposed in the vicinity of the magnetic sensor, and the magnet is constituted so as to be tilted integrally with the operation knob. In addition, since the magnet approaches or separates from the magnetic sensor according to the rotation operation of the operation knob, a magnetic field of the magnet detected by the magnetic sensor is varied, and the signal according to the rotational operation position of the operation knob is taken out. For example, when the magnetic sensor detects that the operation knob is rotationally operated until a predetermined push position, a signal which drives the motor in a normal direction is output, and an opening operation of the power window is performed. Moreover, when the magnetic sensor detects that the operation knob is rotationally operated in a reverse direction until a predetermined pull position, a signal which drives the motor in a reverse direction is output, and a closing operation of the power window is performed.

GB 2 375 890 A discloses a tilting operation type input device having certain features of the device as presently claimed, namely a housing having a pair of bearing portions which support a one-piece shaft; an operation knob having side wall portions with attaching holes facing that bearing portions of the housing; a circuit substrate accommodated within the housing, detection means (a magnetic sensor) mounted on the circuit substrate and a body to be detected (a magnetic body) driven by the operation knob and rotated integrally therewith. The operation knob is fastened to the shaft by being rotatably supported by the that bearing portions.

### SUMMARY OF THE INVENTION

Then, in the above-described tilting operation type input device of the related art, in order to close the body to be detected (the magnet) to the detection means (the magnetic sensor) assembled down the operation knob, the body to be detected constituted so as to be tilted at a position which is separated at a certain distance from a central line of rotation of the operation knob. However, if the distance from the body to be detected to the rotation center line of the operation knob is not set to be short, since an error is likely to occur between the rotation operation of the operation knob and the rotation operation of the body to be detected, it is difficult to obtain high detection accuracy. Therefore, although the above-described input device of the related art can be used as a switch device or the like for detecting ON/OFF states, it is difficult to sensitively detect the rotational operation angle of the operation knob through the input device of the related art. For example, the input device of the related art is not adequate to take out an analog input signal according to the rotational operation angle of the operation knob. is

Thus, a configuration is considered in which the detection means and the body to be detected are disposed in the vicinity of the rotation center line of the operation knob. However, when the configuration is adopted, another problem in that the detection means or the body to be detected is likely to interfere with a supporting shaft of the operation knob occurs. That is, in a case where the tilting operation type input device applying relatively great operation force to the operation knob is used, generally, both end portions of the supporting shaft constituted from a metal shaft or the like attached to the operation knob are supported by a housing. Therefore, in order to avoid the inference with the supporting shaft, the detection means and the body to be detected are necessarily disposed so as to be separated at a certain distance from the rotation center line of the operation knob.

An advantage of some aspects of the invention is to provide a tilting operation type input device capable of easily improving detection accuracy, and of easily securing a mechanical strength which can endure a great operation force in a rotatable attachment configuration of an operation knob.

According to an embodiment of the invention, there is provided a tilting operation type input device including the features of claim 1.

In the tilting operation type input device constituted above, the shafts serving as rotation shafts are fitted in the both side wall portions of the knob attaching member covered with the operation knob and are assembled to the housing, the fixing screws are fastened to the shafts, and the operation knob and the knob attaching member are integrated. Therefore, the operation knob and the knob attaching member can be rotatably attached to the housing. In addition, the region, which is cut across the rotation center line of the operation knob without interfering with the shafts between the bearing portions facing each other in the housing, can be reasonably secured. Moreover, since the detection means and the body to be detected are disposed in the region, the distance from the body to be detected to the rotation center line of the operation knob can be set to be short, and it is needless to say that the body to be detected can be disposed in the rotation center line of the operation knob. Therefore, an error almost does not occur between the rotation operation of the operation knob and the rotation operation of the body to be detected, and the detection can be performed with a high degree of accuracy. In addition, the shafts having a high mechanical strength can be used at a short length, and the mechanical strength, which can endure a great operation force in a rotatable attachment configuration of the operation knob, can be easily secured. Therefore, the endurance can be easily improved.

In the above-described configuration, the detection means may be a magnetic sensor, and the body to be detected may be a magnet. The magnetic sensor and the magnet may approach and face each other in the region cutting across the rotation center line of the operation knob, and a driving portion being provided in the knob attaching member and a magnet holder holding the magnet may be engaged in the region cutting across the rotation center line of the operation knob. Therefore, a contact failure due to abrasion, which is of concern in a contact type detection mechanism, can be avoided, and lengthening of service life is improved.

In the above-described configuration, a cam surface may be provided in the housing, actuators elastically abutting the cam surface may be held to the knob attaching member, and the actuators may be slid along the cam surface when the operation knob is rotationally operated. Therefore, since the operation force with respect to the operation knob is distributed to and applied to the shafts and the actuators, stress concentration almost does not occur, and the endurance is improved. In addition, by using the cam surface when rotationally operating the operation knob, a click feeling is easily generated.

In addition, in the above-described configuration, light guiding bodies may be interposed between the operation knob and the knob attaching member. Therefore, since the operation knob is illuminated from the rear surface of the operation knob, the light guiding bodies can be easily assembled to a predetermined position.

Moreover, in the above-described configuration, concave stepped-portions of D cut-shape blocked by side wall portions of the operation knob may be provided in the fitting holes of the knob attaching member, and engaging flange portions engaged in the concave stepped-portions may be provided in the shafts. Therefore, by only fitting the shafts in the fitting holes when assembling, rotation of the shafts with respect to the knob attaching member is stopped. In addition, by only covering the operation knob to the knob attaching member, it is possible to prevent the shafts from dropping out, and assembly workability can be improved.

According to the tilting operation type input device, the shafts serving as rotation shafts are fitted in the both side wall portions of the knob attaching member and assembled to the housing, the fixing screws are fastened to the shafts, and the operation knob and the knob attaching member are integrated. Therefore, the operation knob and the knob attaching member can be rotatably attached to the housing. In addition, the region, which cuts across the rotation center line of the operation knob without having the interference with the shafts between the bearing portions facing each other in the housing, can be reasonably secured. Moreover, since the detection means or the body to be detected are disposed in the region, the distance from the body to be detected to the rotation center line of the operation knob can be set to be short, an error can be easily suppressed between the rotation operation of the operation knob and the rotation operation of the body to be detected, and the input device having a high detection accuracy can be easily realized. Moreover, the shafts having a high mechanical strength can be used at a short length, and the mechanical strength, which can endure a great operation force in a rotatable attachment configuration of the operation knob, can be easily secured. Therefore, the endurance of the input device can be easily improved. In addition, since the operation knob is formed as the exterior case of the knob attaching member, a forming process of the operation knob in the input device is easily performed.

### BRIEF DESCRIPTION OF THE DRAWINGS

Fig. 1 is an outline view showing a tilting operation type input device according to an embodiment of the invention;
Fig. 2 is an outline view showing the input device of Fig. 1 when viewing the input device in a direction other than the direction of Fig. 1;
Fig. 3 is an exploded perspective view of the input device;
Fig. 4 is a cross-sectional view of the input device;
Fig. 5 is an exploded perspective view to describe a rotatable attachment configuration of an operation knob in the input device;
Figs. 6A to 6D are explanatory views showing an assembly procedure when an operation knob and a knob attaching member are assembled to a housing, which are included in the input device;
Fig. 7 is a main portion perspective view corresponding to Fig. 6A; and
Fig. 8 is a main portion perspective view corresponding to Fig. 6B.

### DESCRIPTION OF THE PREFERRED EMBODIMENTS

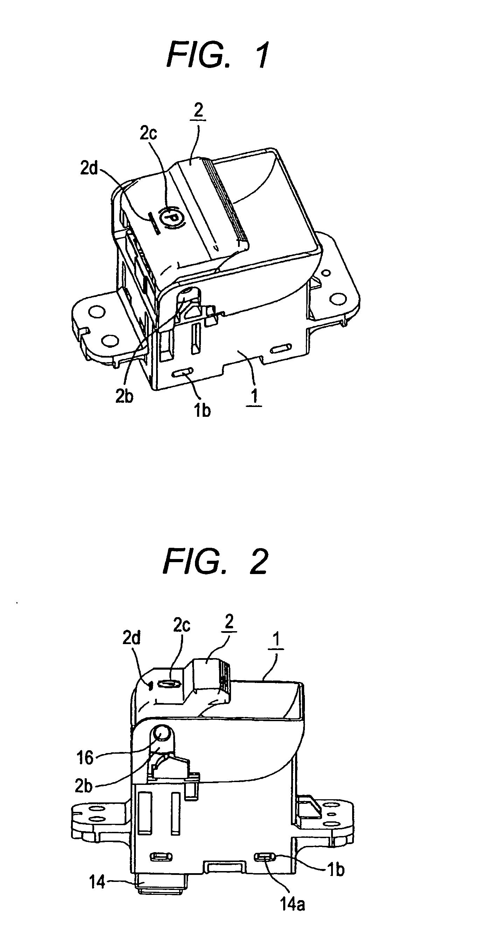

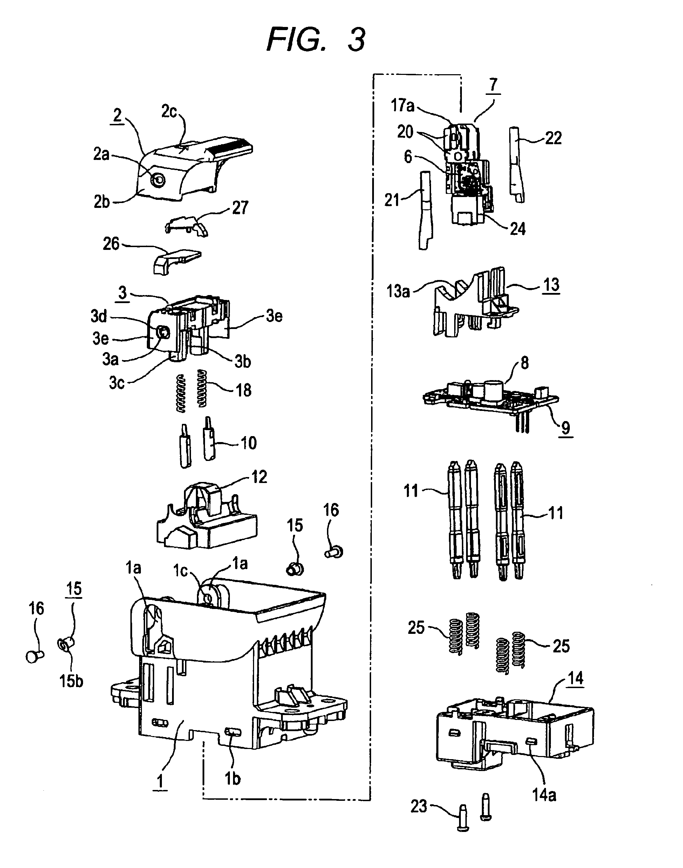

Hereinafter, embodiments of the invention will be described with reference to the accompanying drawings. Figs. 1 to 5 show a tilting operation type input device, for example, the tilting operation type input device is used as a controller or the like that electronically controls a parking brake of automobile. The tilting operation type input device mainly includes as follows: a housing 1 that is made from synthetic resins; an operation knob 2 that is rotatably supported to bearing wall portions 1a of the housing 1 and is capable of operating the knob; a knob fitting member 3 (a knob attaching member) that is integrated to a rear surface side of the operation knob 2; a detection unit 7 that includes a magnet 4 (the body to be detected) held to a magnet holder 17 or a magnetic sensor 5 (a detecting means) mounted on a sub-substrate 6, and the like; a main substrate 9 on which a control circuit 8 is provided; two actuators 10 for click that are pressed and driven by the operation knob 2; four return-only actuators 11; a dustproof and waterproof cover 12 that covers the detection unit 7 or the like; a cam member 13 on which a cam surface 13a sliding the actuators 10 is provided; a cover 14 that covers an opening of an inner side of the housing 1; shafts 15 that are rotation axes of the operation knob 2 and the knob fitting member 3 and are pivotally supported to the bearing wall portions 1a; and fixing screws 16 that is fastened to the shafts 15. In addition, the detection unit 7, the main substrate 9, the actuators 10 and 11, the cover 12, the cam member 13, or the like are all housed in the housing 1.

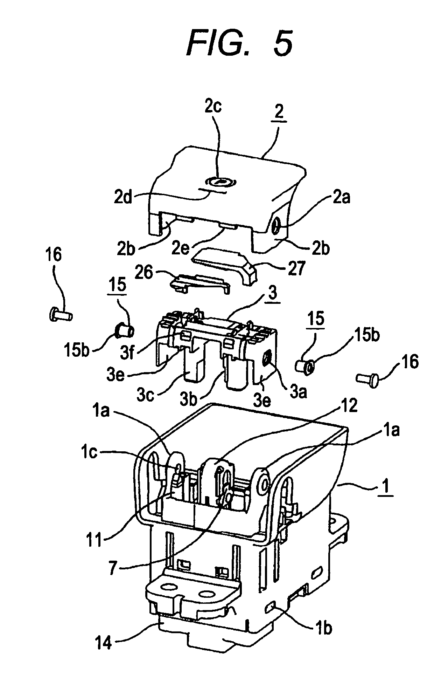

The bearing wall portions 1a are installed at positions facing each other in an upper portion of the housing 1. The shafts 15 each are inserted in shaft holes 1c of two bearing wall portions 1a, and are rotatably and pivotally supported. As described hereinafter, the operation knob 2 and the knob fitting member 3 are integrated by fastening the fixing screws 16 to the shafts 15, and the operation knob 2 and the knob fitting member 3 are rotatably supported to the bearing wall portions 1a of the housing 1 via the shafts 15. In addition, as shown in Fig. 5, a detection unit 7 is disposed in an approximate center portion between a pair of bearing wall portions 1a of the housing 1, and the detection unit 7 is covered by the dustproof and waterproof cover 12.

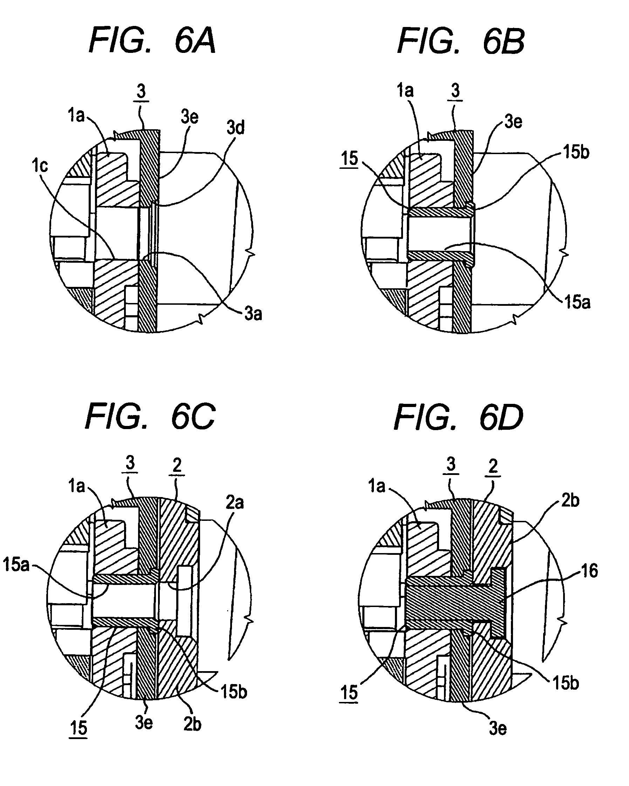

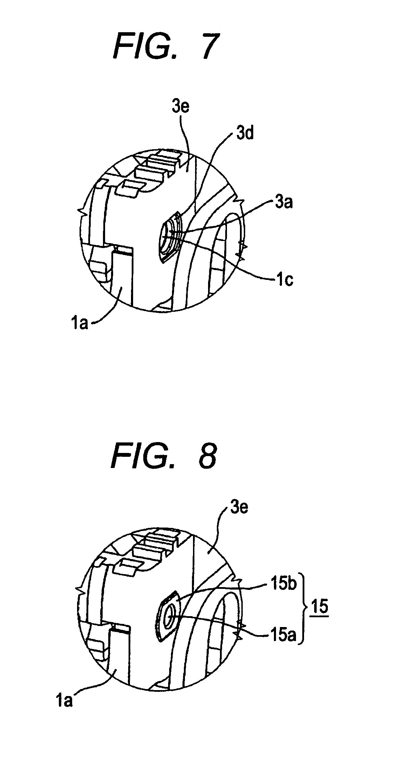

Attaching holes 2a are formed in both side wall portions 2b of the operation knob 2, and fitting holes 3a are formed in both side wall portions 3e of the knob fitting member 3. The operation knob 2 covers the exterior of the fitting member 3, by fastening the fixing screws 16 penetrating the attaching hole 2a to the metallic shafts 15 fitted in the fitting hole 3a, the operation knob 2 and the knob fitting member 3 are integrated. The both side wall portions 3e of the knob fitting member 3 are disposed so as to interpose a pair of bearing wall portions 1a of the housing 1, and the shafts 15 are engaged in the shaft holes 1c of the housing 1 from the fitting holes 3a side of the knob fitting member 3. In addition, the operation knob 2 covers the exterior of the knob attaching member 3, the attaching holes 2a faces the fitting holes 3a, and the fixing screws 16 inserted from the attaching holes 2a side are fastened to the shafts 15. As shown in Figs. 6A to 6D and 7, concave stepped-portions 3d, which are widened in D cut-shape, are formed in the fitting holes 3a of the knob fitting member 3. In addition, the concave stepped-portions 3d are blocked by the side wall portions 2b of the operation knob 2. Moreover, as shown in Figs. 6A to 6D and 8, female screws 15a are provided in inner peripheries of the shafts 15, which are formed as tubular. The fixing screws 16 are screwed to the female screws 15a, and non-circular engaging flange portions 15b, which are installed in one end portion of the shafts 15, are engaged in the concave stepped-portions 3d of the fitting holes 3a. That is, the shafts 15 are fitted in the fitting holes 3a in a state where the rotation of the shafts is stopped, and by fastening the fixing screws 16 to the shafts 15 and securing the operation knob 2, the shafts 15, the knob attaching member 3, and the operation knob 2 always can be integrally rotated.

Here, an assembly procedure when assembling the operation knob 2 and the knob fitting member 3 to the housing 1 will be described in detail with reference to Figs. 6A to 8. First, as shown in Figs. 6A and 7, the knob fitting member 3 is assembled to cover a pair of bearing wall portions 1a from above the housing 1, and the respective fitting holes 3a face the respective shaft holes 1c. Next, as shown in Figs. 6B and 8, the shafts 15 are inserted from the outside of the side wall portions 3e of the knob attaching member 3 into the fitting holes 3a, cylindrical portions of the shafts 15 are engaged to the shaft holes 1c, and the engaging flange portions 15b of the shafts are fitted in the concave stepped-portions 3d of the fitting holes 3a. Thereby, by engaging the non-circular engaging flange portions 15b and the concave stepped-portions 3d to each other, the shafts 15 are fitted in the knob fitting member 3 in a state where the rotation of the shafts is stopped. In addition, since inner wall surfaces of the shaft holes 1c are formed as smooth cylindrical surfaces which have the approximately same inner diameter as the outer diameter of the cylindrical portions of the shafts 15, the shafts 15 are rotatably and pivotally supported in the bearing wall portions 1a.

Next, as shown in Fig. 6C, by covering the operation knob 2 to the knob fitting member 3 from above the housing 1 and by snap-connecting the operation knob 2 and the knob fitting member 3, the respective attaching holes 2a face hollow portions of the respective shafts 15. The snap-connection means that snap claws 2e (refer to Fig. 5) formed in a plurality of places of the operation knob 2 are locked to locking portions 3f (refer to Fig. 5) corresponding to the knob fitting member 3. Therefore, an external fitting operation in which the operation knob 2 serving as the exterior case is attached to the knob fitting member 3 is easily performed. When the operation knob 2 is out-fitted to the knob fitting member 3, in the shafts 15 fitted in the fitting holes 3a, the engaging flange portions 15b in the concave stepped-portions 3d face the side wall portions 2b of the operation knob 2, and the positions of the engaging flange portions 15b are regulated. Therefore, the shafts 15 reach a falling-out stopping state. Thereafter, as shown in Fig. 6D, the fixing screws 16 are inserted from the outsides of the side wall portions 2b of the operation knob 2 into the attaching holes 2a, and the fixing screws 16 are fastened to shafts 15 by screwing the fixing screws 16 to the female screws 15a. Therefore, since the operation knob 2 and the knob fitting member 3 are certainly integrated, the operation knob 2 and the knob fitting member 3 are integrally tilted in a state where the shafts 15 are the rotation axes. In addition, since the shaft central portions of the operation knob 2 and the knob fitting member 3 are integrated, there is no concern of rattling occurring in the rotation operations of the operation knob 2 and the knob fitting member 3.

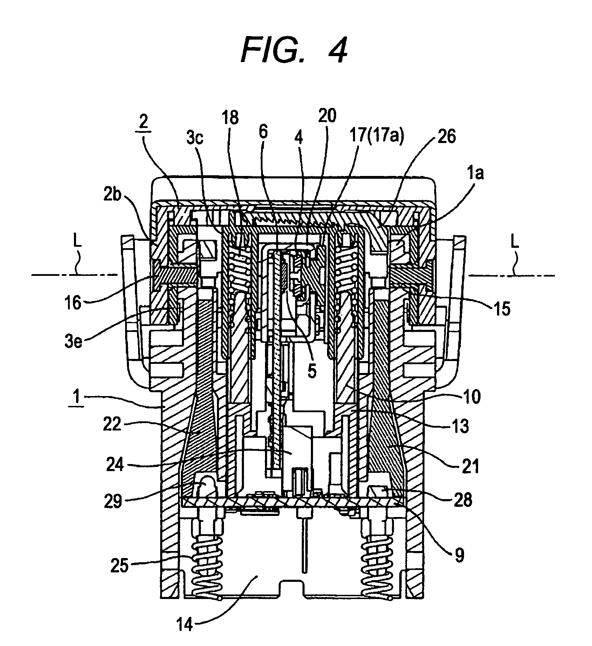

In the front wall portion of the operation knob 2, an illumination portion 2c for display function which is illuminated by a light guiding body 26 and an illumination portion 2d for indicator which is illuminated by a light guiding body 27 are provided. A rear end surface of the one light guiding body 26 faces a front end surface of a light pipe 21, and a rear end surface of the other light guiding body 27 faces a front end surface of a light pipe 22. As shown in Fig. 4, LEDs 28 and 29 are mounted on a main substrate 9 as light sources, since light emitted from the respective LEDs 28 and 29 is guided to the light pipes 21 and 22 and introduced to the light guiding bodies 26 and 27, the illumination portions 2c and 2d of the operation knob 2 can be illuminated from the rear surface side. In addition, the light guiding bodies 26 and 27 are positioned in a front surface side (an upper surface side in Fig. 5) of the knob fitting member 3 and assembled, and the operation knob 2 and the knob fitting member 3 are fixed to each other by externally fitting the operation knob 2 to the knob fitting member 3.

Between both side wall portions 3e of the knob fitting member 3, a driving portion 3b that locks a driven portion 17a of the magnet holder 17 and rotationally drives the driven portion, two guide tubes 3c in which two actuators 10 are slidably inserted, and four pressing portions (not shown) that can press and drive four actuators 11 are provided. Coil springs 18 are inserted in the respective guide tubes 3c, the actuators 10 are biased by the coil springs 18 and always abutted to the cam surface 13a of the cam member 13.

The detection unit 7 detects a rotational operation angle of the operation knob 2. As shown in Fig. 4, the detection means 7 mainly includes as follows: the magnet 4 that is an annular permanent magnet in which the N pole and S pole are magnetized in a position separating the N pole and S pole by 180° from each other; the sub-substrate 6 that cuts across the rotation center line L of the operation knob 2; the magnetic sensor 5, such as a GMR, that is mounted on the sub-substrate 6 and approaches and faces the magnet 4; the magnet holder 17 that holds the magnet 4 and is made from a synthetic resin; and a magnetic shield case 20 that is made of a metal sheet and has a box-shape. The magnet 4 and the magnetic sensor 5 are disposed at regions which cut across the rotation center line L of the operation knob 2 between the bearing wall portions la of the housing 1 facing each other. The magnet 4 and the magnetic sensor 5 are covered by the magnetic shield case 20, and the magnetic shield case 20 is electrically connected to a grounded conductor of the sub-substrate 6. The driven portion 17a, which is disposed on the outside of the magnetic shield case 20, is installed in the magnet holder 17. Since the driven portion 17a is locked to the driving portion 3b of the knob fitting member 3. Therefore, when the operation knob 2 is rotationally operated, the magnet holder 17 is driven, and the operation knob 2 and the magnet holder 17 are integrally rotated. Thus, the operation knob 2 and the magnet 4 are always integrally rotated about the rotation center line L. In addition, a connector 24 is mounted on the sub-substrate 6 so as to output the signal from the magnetic sensor 5 to the main substrate 9.

The main substrate 9 is set on and fixed to the cover 14 by using the fixing screws 23, and the cam member 13 is set on and fixed to the main substrate 9 by screws or the like. A trough and a stepped-portion are formed in the cam surface 13a of the cam member 13, and when the operation knob 2 is rotationally operated, the actuators 10 slide on the cam surface 13a in conjunction with the rotation operation of the operation knob 2.

Claws 14a are provided in a plurality of places of the outer wall surface of the cover 14, and by engaging the claws 14a to lock holes 1b corresponding to the housing 1, the cover 14 is snap-connected to the housing 1. The rear end portions of the actuators 11 and the coil springs 25 are housed in one section in the cover 14. In addition, when the operation knob 2 is rotationally operated toward the front (a pull operation), the actuators 11 that is pressed and driven in the pressing portion of the knob fitting member 3 slide the inside. Therefore, the actuators 11 elastically press the coil springs 25, and when the operation force with respect to the operation knob 2 is removed, the actuators 11 are slid front by the elastic restoring force of the coil springs 25 and push the knob fitting member 3 back.

Next, operation of the tilting operation type input device constituted as above will be described. When the operation knob 2 is not operated (during non-operation), since the actuators 10 are held to the trough of the cam surface 13a, the operation knob 2 is held to non-inclined orientation.

When user grips the operation knob 2 and performs the pull operation to rotate toward the front, since the knob fitting member 3 is integrally rotated with the operation knob 2, the driving portion 3b rotationally drives the driven portion 17a, and the magnet holder 17 and the magnet 4 are integrally rotated with the operation knob 2. In this time, since the direction of a magnetic field generated in the magnet 4 is rotated only by the same angle as that of the operation knob 2, the magnetic field of the magnet 4 detected by the magnetic sensor 5 is greatly changed according to the rotational operation angle of the operation knob 2. That is, the rotational operation angle of the operation knob 2 can be understood with a high degree of accuracy based on the detected signal of the magnetic sensor 5. Therefore, in the tilting operation type input device according to the present embodiment, the signal output from the magnetic sensor 5 to the control circuit 8 of the main substrate 9 is appropriately processed. Thus, a braking force of a parking brake, which is an object to be controlled, is increased in an analog manner according to the size of the rotational operation angle.

In addition, according to the operation knob 2 that is performed with the pull-operation, the actuators 10 slide on the cam surface 13a while elastically pressing the coil springs 18, and the actuators 11 slide inside while elastically pressing the coil springs 25. Moreover, at the time when the rotational operation angle of the operation knob 2 reach a predetermined dimension, the actuators 10 ride over the stepped-portion of the cam surface 13a, and a click feeling is generated. At this time, the rotational operation angle is detected by the magnetic sensor 5. As a result, the signal at which the braking force of the parking brake becomes the maximum is output to the control circuit 8.

In addition, when the operating force with respect to the operation knob 2 is removed, the actuators 10 are pushed back toward the trough of the cam surface 13a by the elastic restoring force of the coil springs 18, and the actuators 11 slide toward the front by the elastic restoring force of the coil springs 25. Therefore, the knob attaching member 3 is pushed back to the initial position of the knob fitting member 3 by the actuators 10 and 11. Thereby, the operation knob 2 is automatically returned to the initial position.

As described above, in the tilting operation type input device according to the present embodiment, the shafts 15 serving as the rotation shafts are fitted in the both side wall portions 3e of the knob fitting member 3 covered with the operation knob 2 and assembled to the housing 1, the fixing screws are fastened to the shafts 15, and the operation knob 2 and the knob attaching member 3 are integrated. Therefore, the operation knob 2 and the knob attaching member 3 can be rotatably attached to bearing wall portions 1a of the housing 1. Moreover, the region, which is cut across the rotation center line L of the operation knob 2 without interfering with the shafts 15 between the bearing portions 1a of the housing 1 facing each other, can be reasonably secured. In addition, since the magnetic sensor 5 or magnet 4 are disposed in the region and the magnet 4 is set in the rotation center line L, in the input device, error between the rotation operation of the operation knob 2 and the rotation operation of the magnet 4 is very small, and the high detection accuracy can be obtained. In addition, the shafts 15 having a high mechanical strength can be used at a short length, and the mechanical strength, which can endure a great operation force in a rotatable attachment configuration of the operation knob 2, can be easily secured. Therefore, in the input device, the endurance can be easily improved. In addition, since the operation knob 2 can be formed as the exterior case of the knob attaching member 3, a molding of the operation knob 2 in the input device is easily performed.

Moreover, in the tilting operation type input device according to the present embodiment, the cam surface 13a may be fixed to and installed in the housing 1, actuators 10 elastically abutting the cam surface 13a may be held to the guide tubes 3c of the knob attaching member 3, and the actuators 10 biased to the operation knob 2 when rotationally operating the operation knob 2 may be slid along the cam surface 13a, and the return-only actuators 11 also may be biased to the operation knob 2. Therefore, even though the operation force is excessively great with respect to the operation knob 2, since the operation force is distributed to and applied to the shafts 15 and the actuators 10 and 11, stress concentration almost does not occur, and the endurance is easily improved. In addition, when rotationally operating the operation knob 2, since the click feeling can be generated by using the cam surface 13a, operability also is improved.

Moreover, in the tilting operation type input device according to the present embodiment, the light guiding bodies 26 and 27 may be interposed between the operation knob 2 and the knob attaching member 3. Therefore, since the operation knob 2 is illuminated from the rear surface of the operation knob 2, the light guiding bodies 26 and 27 can be easily assembled to a predetermined position.

In the tilting operation type input device according to the present embodiment, the concave stepped-portions 3d of D cut-shape blocked by side wall portions 2b of the operation knob 2 may be provided in the fitting holes 3a of the knob attaching member 3, and the engaging flange portions 15b engaged in the concave stepped-portions 3d may be provided in the shafts 15. Therefore, by only fitting the shafts 15 in the fitting holes 3a when assembling, rotation of the shafts 15 with respect to the knob attaching member 3 is stopped. In addition, by only covering the operation knob 2 to the knob attaching member 3, it is possible to prevent the shafts 15 from dropping out. Therefore, assembly workability of the input device can be improved.

In addition, in the embodiment, since the tilting operation type input device applying the great operation force to the operation knob 2 is exemplified, the return-only actuators 11 and the coil springs 25 are used in addition to the click actuators 10 and the coil springs 18. However, when the tilting operation type input device which does not require especially great operation force is used, the tilting operation type input device can be stably operated even though the actuators 11 or the coil springs 25 is omitted. In addition, in the embodiment, the tilting operation type input device capable of performing only pull operation of the operation knob 2 is exemplified. However, needless to say, the invention can be applied to the input device capable of performing only the push operation, or also to the input device capable of selectively performing the pull operation or the push operation.

Moreover, in the embodiment, in order to detect the rotational operation angle of the operation knob 2, the magnetic sensor 5 approaches and faces the magnet 4 which is integrally rotated with the operation knob 2. However, even in a case in which the contact type detection mechanism sliding the slider to the conductive pattern is disposed in the region which cuts across the rotation center line L of the operation knob 2, since error between the rotation operation of the operation knob 2 and the rotation operation of the slider can be suppressed, the high detection accuracy can be obtained. However, in the contact type detection mechanism, if the detection mechanism is used over long period, contact failure due to the abrasion is of concern. Therefore, when the non-contact type detection mechanism is adopted as the present embodiment, the service life can be further lengthened.

It should be understood by those skilled in the art that various modifications, combinations, sub-combinations and alterations may occur depending on design requirements and other factors insofar as they are within the scope of the appended claims.

## Claims

1. A tilting operation type input device comprising:
tubular shafts (15, 15) being provided with female screw
portions in inner peripheries of the shafts;
a knob attachment member (3) having side wall portions (3e) including
fitting holes (3a) into which the shafts each are fitted in a state of stopping the rotation of the shafts;
a housing (1) being provided in a position in which a pair of bearing portions (1a) pivotally supporting the shafts face each other;
a operation knob (2) covering the exterior of the knob attachment member in a state in which attaching holes (2a) installed in the both side wall portions (2b) each faces the fitting holes;
fixing screws (16, 16) penetrating the attaching holes and being screwed to the female screw portions;
a circuit substrate (6) being housed in the housing so as to cut across a rotation center line of the operation knob;
a detection means (5) being mounted on the circuit substrate; and
a body to be detected (4) being driven by the knob attaching member and rotated integrally with the knob attaching member,
wherein the operation knob (2) and the knob attaching member (3)
are integrated by fastening the fixing screws to the shafts (15), the operation knob (2) and the knob attaching member (3) are rotatably supported to the bearing portions via the shafts (15), the detection means (5) and the body to be detected (4) are disposed in a region cutting across the rotation center line of the operation knob between the bearing portions facing each other, and the detection means and the body to be detected approach or abut each other.

2. The tilting operation type input device according to claim 1,
wherein the detection means is a magnetic sensor, the body to be detected is a magnet, the magnetic sensor and the magnet approach and face each other in the region cutting across the rotation center line of the operation knob, and a driving portion (3b) being provided in the knob attaching member and a magnet holder holding the magnet are engaged in the region cutting across the rotation center line of the operation knob.

3. The tilting operation type input device according to claim 1 or 2,
wherein a cam surface (13a) is provided in the housing, actuators (10, 10) elastically abutting the cam surface are held to the knob attaching member, and the actuators slides along the cam surface when the operation knob is rotationally operated.

4. The tilting operation type input device according to any one of claims 1 to 3,
wherein light guiding bodies (26, 27) are interposed between the operation knob and the knob attaching member.

5. The tilting operation type input device according to any one of claims 1 to 4,
wherein concave stepped-portions (3d) of D cut-shape blocked by side wall portions of the operation knob is provided in the fitting holes, and engaging flange portions (15b) engaged in the concave stepped-portions is provided in the shafts.

## Patentansprüche

1. Eingabevorrichtung vom Kippbetätigungs-Typ, aufweisend:
rohrförmige Zapfen (15, 15), die am Innenumfang der Zapfen mit Innengewindebereichen versehen sind;
ein Tasten-Befestigungselement (3) mit Seitenwandbereichen (3e),
die Einpassöffnungen (3a) aufweisen, in die die Zapfen jeweils derart eingepasst sind, dass eine Rotation der Zapfen gestoppt ist;
ein Gehäuse (1), das in einer Position vorgesehen ist, in der ein Paar Lagerbereiche (1a), die die Zapfen schwenkbar tragen, einander gegenüberliegend vorgesehen sind;
eine Betätigungstaste (2), die das Äußere des Tasten-Befestigungselements in einem Zustand überdeckt, in dem in den beiden Seitenwandbereichen (2b) vorgesehene Befestigungsöffnungen (2a) jeweils den Einpassöffnungen zugewandt gegenüberliegen;
Befestigungsschrauben (16, 16), die die Befestigungsöffnungen durchsetzen und in die Innengewindebereiche geschraubt sind;
ein Schaltungssubstrat (6), das in dem Gehäuse derart untergebracht ist, dass es eine Rotationsmittellinie der Betätigungstaste schneidet;
eine Erfassungseinrichtung (5), die an dem Schaltungssubstrat angebracht ist: und
einen zu erfassenden Körper (4), der durch das Tasten-Befestigungselement antriebsmäßig bewegt wird und integral mit dem Tasten-Befestigungselement rotationsmäßig bewegt wird,
wobei die Betätigungstaste (2) und das Tasten-Befestigungselement (3) durch Befestigen der Befestigungsschrauben an den Zapfen (15) integriert ausgebildet sind, wobei die Betätigungstaste (2) und das Tasten-Befestigungselement (3) über die Zapfen (15) an den Lagerbereichen drehbar gelagert sind, wobei die Erfassungseinrichtung (5) und der zu erfassende Körper (4) in einer Region angeordnet sind, die die Rotationsmittellinie der Betätigungstaste zwischen den einander zugewandt gegenüberliegenden Lagerbereichen schneidet, und wobei die Erfassungseinrichtung und der zu erfassende Körper sich aneinander annähern oder aneinander anliegen.

2. Eingabevorrichtung vom Kippbetätigungs-Typ nach Anspruch 1, wobei die Erfassungseinrichtung ein magnetischer Sensor ist und der zu erfassende Körper ein Magnet ist, wobei der magnetische Sensor und der Magnet in der Region, die die Rotationsmittellinie der Betätigungstaste schneidet, sich aneinander annähern und einander flächig gegenüberliegen, und wobei ein in dem Tasten-Befestigungselement vorgesehener Antriebsbereich (3b) und ein den Magneten haltender Magnethalter in der Region zusammenwirken, die die Rotationsmittellinie der Betätigungstaste schneidet.

3. Eingabevorrichtung vom Kippbetätigungs-Typ nach Anspruch 1 oder 2,
wobei eine Steuerfläche (13a) in dem Gehäuse vorgesehen ist, wobei an der Steuerfläche elastisch anliegende Aktuatoren (10, 10) an dem Tasten-Befestigungselement gehalten sind, und wobei die Aktuatoren entlang der Steuerfläche verschoben werden, wenn die Betätigungstaste rotationsmäßig betätigt wird.

4. Eingabevorrichtung vom Kippbetätigungs-Typ nach einem der Ansprüche 1 bis 3,
wobei Lichtführungskörper (26, 27) zwischen der Betätigungstaste und dem Tasten-Befestigungselement angeordnet sind.

5. Eingabevorrichtung vom Kippbetätigungs-Typ nach einem der Ansprüche 1 bis 4,
wobei konkave Stufenbereiche (3d), die im Querschnitt D-förmig ausgebildet sind und von Seitenwandbereichen der Betätigungstaste blockiert sind, in den Einpassöffnungen vorgesehen sind und Eingriffsflanschbereiche (15b), die in die konkaven Stufenbereiche greifen, an den Zapfen vorgesehen sind.

## Revendications

1. Dispositif d'entrée du type à actionnement basculant comprenant :
des axes tubulaires (15, 15) pourvus de parties à filetage femelle dans les périphéries intérieures des axes ;
un élément de fixation de bouton (3) ayant des parties de paroi latérale (3e) comprenant des trous d'assemblage (3a) dans lesquels sont logés chacun des axes dans un état d'arrêt de la rotation des axes ;
un boîtier (1) étant prévu dans une position dans laquelle une paire de parties de support (1a) supportant les axes de façon pivotante sont en face l'une de l'autre ;
un bouton d'actionnement (2) couvrant l'extérieur de l'élément de fixation de bouton dans un état dans lequel des trous de fixation (2a) formés dans les deux parties de paroi latérale (2b) font face chacun aux trous d'assemblage ;
des vis de fixation (16, 16) pénétrant dans les trous de fixation et vissées dans les parties à filetage femelle ;
un substrat de circuit (6) étant logé dans le boîtier de manière à couper un axe de rotation du bouton d'actionnement ;
un moyen de détection (5) étant monté sur le substrat de circuit ; et
un corps à détecter (4) étant entraîné par l'élément de fixation de bouton et tournant d'un seul tenant avec l'élément de fixation de bouton,
dans lequel le bouton d'actionnement (2) et l'élément de fixation de bouton (3) sont intégrés en serrant les vis de fixation sur les axes (15), le bouton d'actionnement (2) et l'élément de fixation de bouton (3) sont supportés à rotation sur les parties de support par l'intermédiaire des axes (15), le moyen de détection (5) et le corps à détecter (4) sont placés dans une région qui coupe l'axe de rotation du bouton d'actionnement entre les parties de support qui se font face, et le moyen de détection et le corps à détecter s'approchent l'un de l'autre ou butent l'un sur l'autre.

2. Dispositif d'entrée du type à actionnement basculant selon la revendication 1,
dans lequel le moyen de détection est un capteur magnétique, le corps à détecter est un aimant, le capteur magnétique et l'aimant se rapprochent et se font face dans la région qui coupe l'axe de rotation du bouton d'actionnement, et une partie d'entraînement (3b) prévue dans l'élément de fixation de bouton et un porte-aimant tenant l'aimant sont en prise dans la région coupant l'axe de rotation du bouton d'actionnement.

3. Dispositif d'entrée du type à actionnement basculant selon la revendication 1 ou 2,
dans lequel une surface de came (13a) est prévue dans le boîtier, des actionneurs (10, 10) butant de façon élastique contre la surface de came sont maintenus sur l'élément de fixation de bouton, et les actionneurs glissent le long de la surface de came quand le bouton d'actionnement est actionné en rotation.

4. Dispositif d'entrée du type à actionnement basculant selon l'une quelconque des revendications 1 à 3, dans lequel des corps de guidage de lumière (26, 27) sont intercalés entre le bouton d'actionnement et l'élément de fixation de bouton.

5. Dispositif d'entrée du type à actionnement basculant selon l'une quelconque des revendications 1 à 4, dans lequel des parties étagées concaves (3d) découpées en forme de D bloquées par des parties de paroi latérale du bouton d'actionnement sont prévues dans les trous d'assemblage, et des parties de bride d'assemblage (15b) engagées dans les parties étagées concaves sont prévues sur les axes.
